# EUROPEAN PATENT APPLICATION

(11) **EP 2 341 353 A1**
(43) Date of publication of application: **06.07.2011**
(21) Application number: 10150156.7
(22) Date of filing: 05.01.2010
(51) Int. Cl.: G01R 31/28

(54) **Self-aligning test fixture for printed circuit board**

(71) Applicant: RESEARCH IN MOTION LIMITED, Waterloo, Ontario N2L 3W8 (CA)
(72) Inventor: Jiang, Hongjun, Waterloo Ontario N2L 3W8 (CA); Reksnis Marek, Waterloo Ontario N2L 3W8 (CA); Ivannikov, Arkady, Waterloo Ontario N2L 3W8 (CA)
(74) Representative: MERH-IP Matias Erny Reichl Hoffmann

(57) **Abstract**

A printed circuit board ("PCB") test fixture is provided comprising a PCB support, an electrical tester (30), first and second enclosure portions (200,300), and an actuator. The PCB support is configured for supporting a PCB (100) being tested in a PCB test position. The first enclosure portion includes a pressing device (40) which is configured for effecting, with respect to a PCB supported in the PCB test position on the PCB support, pressing of a circuit of the PCB against the electrical tester so as to provide an operative circuit. The second enclosure portion extending peripherally about the PCB support. The actuator is coupled to a one of the first enclosure portion and the second enclosure portion and configured to effect an application of force to the one of the first enclosure portion and the second enclosure portion. The PCB support is disposed between the first and second enclosure portions.

## Description

### TECHNICAL FIELD

Test fixtures are used for testing the electrical functionality of a printed circuit board ("PCB").

### BACKGROUND OF THE ART

The testing of electronic components or devices during manufacturing involves use of a test fixture to accurately position the device under test so that electrical contacts are properly engaged to perform the test. During the testing, there is potential for interference from background radio frequency energy ("RF").

### SUMMARY OF THE INVENTION

There is provided a printed circuit board ("PCB") test fixture comprising a PCB support, an electrical tester, first and second enclosure portions, and an actuator. The PCB support is configured for supporting a PCB being tested in a PCB test position. The first enclosure portion includes a pressing device which is configured for effecting, with respect to a PCB supported in the PCB test position on the PCB support, pressing of a circuit of the PCB against the electrical tester so as to provide an operative circuit. The second enclosure portion extending peripherally about the PCB support. The actuator is coupled to a one of the first enclosure portion and the second enclosure portion and configured to effect an application of force to the one of the first enclosure portion and the second enclosure portion. The PCB support is disposed between the first and second enclosure portions. When a contact surface portion of the first enclosure portion is disposed in contact engagement along a contact interface with a contact surface portion of the second enclosure portion, and a one of the first enclosure portion and the second enclosure portion is being urged towards the other one of the first enclosure portion and the second enclosure portion by the actuator, and the urging of the one of the first enclosure portion and the second enclosure portion towards the other one of the first enclosure portion and the second enclosure portion by the actuator effects production of a moment about an axis of the contact interface, the moment effects adjustment of the orientation of the first enclosure portion relative to the second enclosure portion.

### DESCRIPTION OF THE DRAWINGS

The implementation will now be described with reference to the following drawings, in which:
Figure 1 is a top perspective view, partly in section, illustrating an implementation of the PCB test fixture in the open position;
Figure 2 is a sectional, top perspective view, partly in section, illustrated the PCB test fixture of Figure 1 in the closed position;
Figure 3 is a sectional side elevation view, illustrating the PCB test fixture of Figure 1 in the closed position;
Figure 4 is a top perspective view, partly in section, of an automatic testing machine including the test fixture of Figure 1;
Figures 5a and 5b illustrate, respectively, an electrical test probe and an electrical test pin;
Figure 6 is a top plan view of one side of a push plate, including an arrangement of pusher fingers;
Figure 7 is a top perspective view of one side of the first set of identical PCB's, supported on the support plate for testing, showing the side of the PCB's which is configured to make contact with the pusher fingers, and for which the arrangement of pusher fingers in Figure 6 is configured;
Figure 8 is a bottom perspective view of another side of the first set of identical PCB's illustrated in Figure 7 and supported on the probe plate for testing, illustrating the side of the PCB's which make contact with the electrical test probes and electrical test pins;
Figure 9 is a top plan view of one side of the push plate illustrated in Figure 6, but including a different arrangement of pusher fingers than that illustrated in Figure 6;
Figure 10 is a bottom perspective view of one side of a second set of identical PCB's supported on the probe plate for testing, illustrating the side of the PCB's which make contact with the electrical test probes and electrical test pins, and for which the arrangement of pusher fingers in Figure 9 is configured;
Figure 11 is a top perspective view of another side of the second set of identical PCB's illustrated in Figure 10, supported on the support plate for testing, showing the side of the PCB's which is configured to make contact with the pusher fingers;
Figure 12 is an exploded view of the push module, the base module, and the mounting assembly of the test fixture of Figure 1, with the push module and base module separated from the mounting adaptor and disposed in a closed condition, ready for maintenance; and
Figure 13 is a top perspective view of the push module and the base module of the test fixture of Figure 1, with the push module and base module separated from the mounting adaptor and disposed in a closed condition, ready for maintenance.

### DETAILED DESCRIPTION

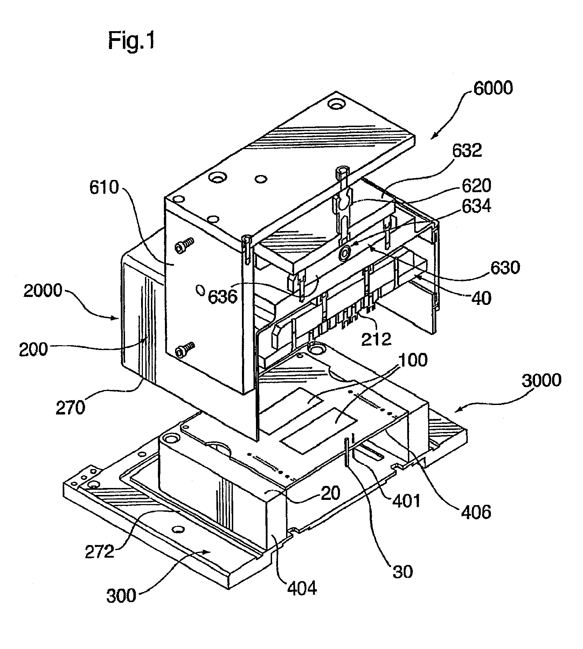

Referring to Figures 1, 2, 3, and 4, there is provided a printed circuit board ("PCB") test fixture 10. The PCB test fixture 10 includes a PCB support 20, an electrical tester 30, and a pressing device 40.

The support 20 is configured for supporting a PCB 100 being tested in a PCB test position 200.

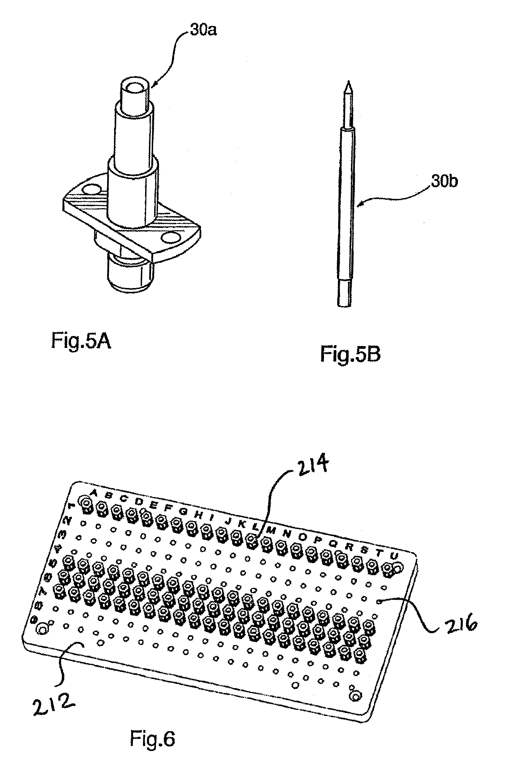

The electrical tester 30 is configured to co-operate with a PCB 100 which is supported in the PCB test position by the PCB support 20. An operative circuit is provided when a circuit of the PCB 100 is disposed in electrical contact with the electrical tester 30. Referring to Figure 5a and 5b, suitable electrical testers 30 include electrical test probes 30a (see Figure 5a) and electrical test pins 30b (see Figure 5b). Electrical test probes 30a are used to detect and receive radio frequency signals. Electrical test pins 30b are used to make contact with testing points on the PCB 100, and receive signals for testing.

There is also provided a first enclosure portion 200 including a pressing device 40 which is configured for effecting, with respect to a PCB 100 supported in the PCB test position on the PCB support 20, pressing of a circuit of the PCB 100 against the electrical tester 30 so as to provide the operative circuit. For example, the first enclosure portion 200 is in the form of a box-like structure.

There is also provided a second enclosure portion 300 extending peripherally about the PCB support 20. In some implementation, the first and second enclosure portions 200, 300 co-operate so as to effect desired RF shielding of the PCB 100 during RF testing.

An actuator 400 is coupled to a one of the first enclosure portion 200 and the second enclosure portion 300 and configured to effect an application of force to the one of the first enclosure portion 200 and the second enclosure portion 300.

When a PCB 100 is supported in the PCB test position by the PCB support 20 and the providing of the operative circuit is being effected:
(a) the first enclosure portion 100 is seated on the second enclosure portion 200 (to define a "chamber 240") such that an internal space 250 is defined between the first enclosure portion 200 and the second enclosure portion 300, wherein the supported and PCB test disposed - PCB 100 is disposed within the internal space 250; and
(b) the actuator 400 is effecting the pressing device 40 to effect the provision of the operative circuit by pressing the supported and PCB test disposed - PCB 100 against the electrical tester 30.

When a contact surface portion of the first enclosure portion 200 is disposed in contact engagement along a contact interface with a contact surface portion of the second enclosure portion 300, and a one of the first enclosure portion 200 and the second enclosure portion 300 is being urged towards the other one of the first enclosure portion 200 and the second enclosure portion 300 by the actuator 400, and the urging of the one of the first enclosure portion 200 and the second enclosure portion 300 towards the other one of the first enclosure portion 200 and the second enclosure portion 300 by the actuator 400 effects production of a moment about an axis of the contact interface, the moment effects adjustment of the orientation of the first enclosure portion 200 relative to the second enclosure portion 300.

In some implementations, the coupling of the actuator 400 to the one of the first enclosure portion 200 and the second enclosure portion 300 is configured to facilitate the adjustment of the orientation of the first enclosure portion 200 relative to the second enclosure portion 300.

In some implementations, the actuator 400 is swivelly mounted to the one of the first enclosure portion 200 and the second enclosure portion 300.

In some implementations, the coupling of the actuator 400 to the one of the first enclosure portion 200 and the second enclosure portion 300 is by way of a swivel coupling 620.

In some implementations, the coupling of the actuator 400 to the one of the first enclosure portion 200 and the second enclosure portion 300 is by way of a ball joint 620.

In some implementations, the pressing device 40 effects pressing of a circuit of a supported and PCB test disposed - PCB 100 against the electrical tester 30 by pressing against the supported and PCB test disposed - PCB 100. In this respect, in some implementations, the pressing of the pressing device 40 against the supported and PCB test disposed - PCB 100 is against a side surface of the supported and PCB test disposed - PCB 100 which is opposite to the side surface of the supported and PCB test disposed - PCB 100 which includes the circuit.

In some implementations, one of the first and second enclosure portions 200, 300 includes a lip 270, and the other one of the first and second enclosure portions 200, 300 includes a RF gasket 273 disposed in a receiving slot 272. The adjustment of the orientation of the first enclosure portion 200 relative to the second enclosure portion 300 effects receiving of the lip 270 by the receiving slot 272 and results in the compression of the RF gasket 273 by the lip 270 (the lip 270 contacts the RF gasket 273 and compresses the RF gasket 273) to effect creation of a RF seal.

In some implementations, the adjustment of the orientation of the first enclosure portion 200 relative to the second enclosure portion 300 effects substantial alignment between the interfacing surfaces of each one of the first and second enclosure portions 200, 300.

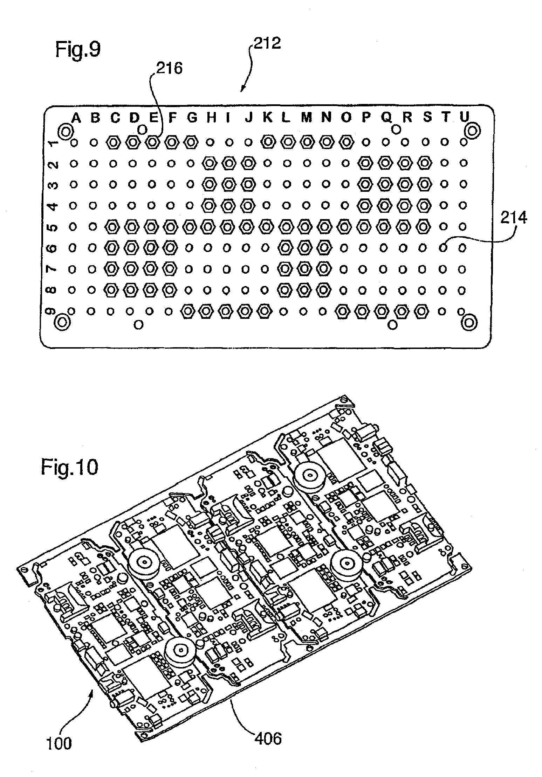

In some implementations, and referring to Figures 6 and 9, with respect to the pressing device 40, the pressing device 40 includes a push plate 212. Referring to Figure 6, the push plate 212 is characterized by a substantially rectangular shape. The illustrated push plate 212 includes a plurality of receptacles 216 in an exemplary form of apertures which are labelled in column from A to U, and in row from 1 to 9 for facilitating convenient locating of pusher members 216. The centre distances between adjacent apertures in both directions are substantially the same. Each one of the plurality of receptacles 216 is configured for releasable coupling to a pusher member 214. The push plate 212 illustrated in Figure 6 is configured for releasable coupling to the pusher member 216 and is shown releasably coupled to a plurality of pusher members 50. With respect to the pusher member 216, a suitable exemplary pusher member 216 is a pusher finger 214 such as McMaster-Carr™ Part No. 94662A431. This pusher finger 214 is releasably coupled to the push plate 212 illustrated in Figure 6 by inserting the pusher finger 214 into one of the apertures provided in the push plate 212. The diameter of the apertures is machined so as to effect an interference fit with the pusher finger 214 upon insertion of the pusher finger 214. The interference fit is not excessively tight, so as to enable removal of the pusher finger 214 from the base plate, and sufficiently tight so as to remain fixed in position relative to the push plate 212 while urging the PCB 100 to be tested against the electrical tester 30.

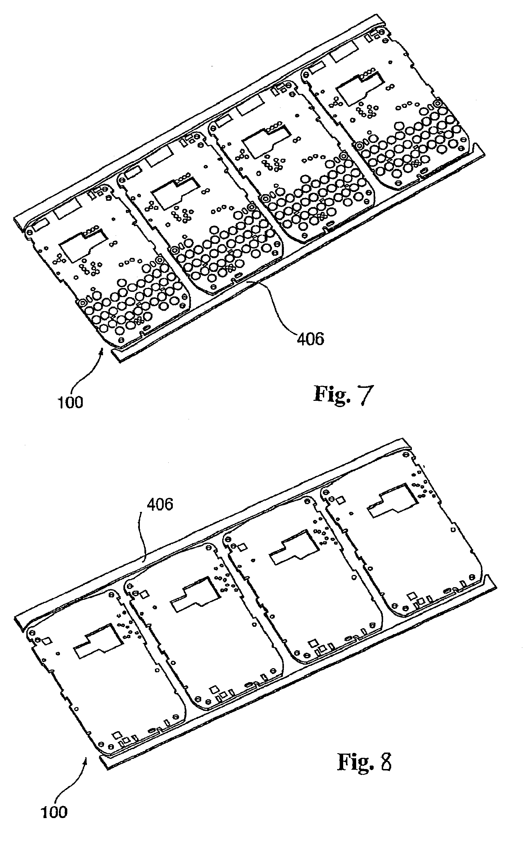

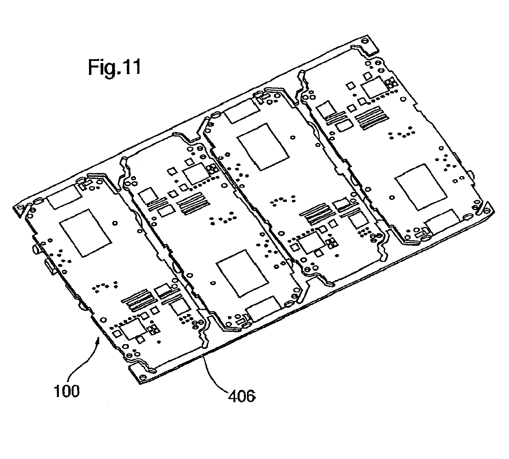

A plurality of pusher members 216 can be releasably coupled to the push plate 212 in different patterns to suit different PCBs 100 to be tested. The spatial arrangement of pusher members 216 in Figure 6 is configured for use when testing three identical PCB's 100 illustrated in Figures 7 and 8. Figure 9 illustrates a further exemplary pattern of pusher members 216 coupled to the push plate 212, different from the pattern illustrated in Figure 6. The Figure 9 arrangement of pusher members 216 is configured for use when testing three identical PCB's 100 illustrated in Figures 10 and 11. In some cases, the surface of a first PCB (Figures 7 and 8) is contoured differently from the surface of a second PCB (Figures 10 and 11), such that one pattern of pusher members 216 for pressing one or more circuits of the first PCB against electrical testers 30 when the first PCB is disposed in a PCB test position would not be suitable for pressing one or more circuits of the second PCB against electrical testers 30 when the second PCB is disposed in a PCB test position.

The push plate 212 is mounted to the pressing device such that the pusher fingers 214 are disposed in a spatial arrangement so as to effect contact with a PCB 100 supported on the support 20 upon moving the pressing device 40 towards the supported PCB 100. Coupling of the push plate 212 to the pressing device 40 is effected using flat head screws which extend though countersink holes provided in the push plate 212 and are thereby threadably received in the pressing device 40.

The push plate 212 is mounted to the first enclosure portion 200 such that the pusher members 216 are disposed in a spatial arrangement so as to effect contact with a PCB 100 supported on the PCB support 20 upon moving the first enclosure portion 200 towards the second enclosure portion 300 and thereby effect pressing of circuits on the PCB 100 against the electrical testers 30.

In some implementation, the test fixture 10 includes a push module 2000 and a base module 4000. The push module 2000 defines the first enclosure portion 200. The base module 3000 defines the second enclosure portion 300. The base module 3000 includes a probe plate 406 which is secured to the PCB support 20 by four spread-apart screws. The probe plate 406 includes radio frequency ("RF") probes 30a, test pins 30b, and support pins 401. The PCB's 100 for testing are supported on the upper surface of the probe plate 406, and are located and further supported by the support pins 401. The probes 30a and pins 30b are provided to effect electrical testing of the supported PCB's.

The push module 2000 co-operates with the base module 3000 to provide a RF shielding chamber 500, which prevents, or substantially prevents, or at least mitigates, RF leakage into the internal space 250 when the push module 2000 is seated against the base module 3000. In this respect, the seating of the push module 2000 against the base module 3000 effects shielding, or effects substantially complete shielding, or effects complete shielding of a PCB 100 disposed in the internal space 250 during RF testing.

The push module 2000 includes the pressing device 40 and the push plate 212.

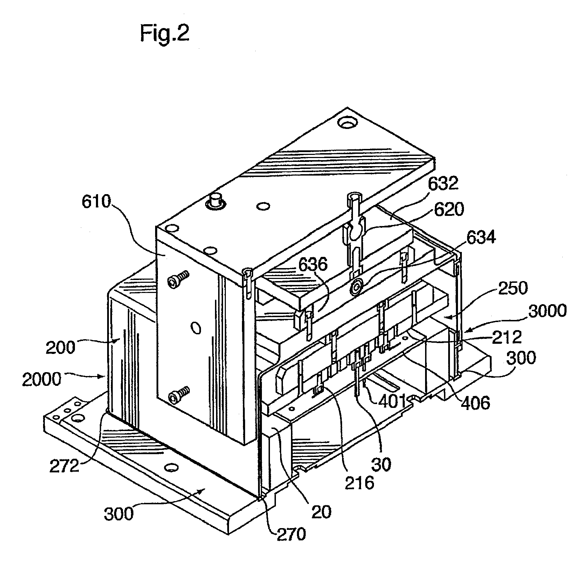

The push module 2000 is mounted to a hydraulic actuator 400, and the hydraulic actuator 400 is configured to effect displacement of the push module 3000 relative to the base module 3000. Figure 2 illustrates the test fixture 10 disposed in the closed condition. Figure 1 illustrates the test fixture 10 in the open position. In the closed condition, a suitable RF testing environment is provided for the RF testing of a PCB 100 disposed in the PCB test position. In the open condition, free space exists between the push module 2000 and the base module 4000 for access by a robotic arm (for example, for providing and/or removing a PCB 100 from the PCB support 20).

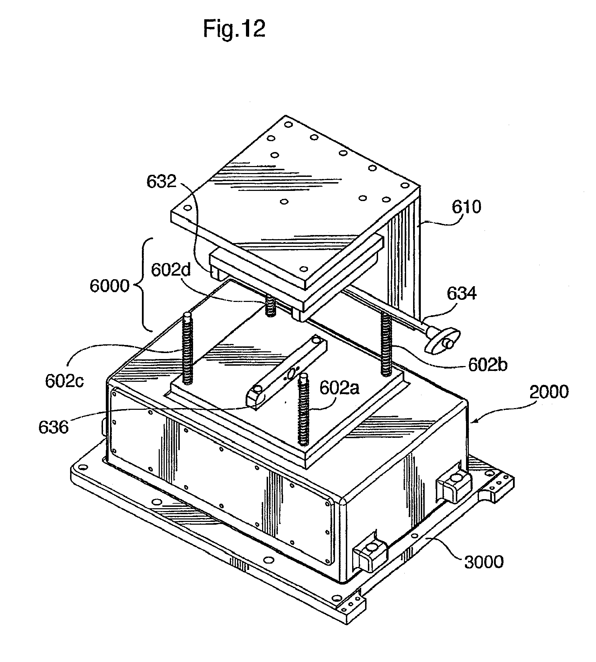

The push module 2000 is releasably coupled to the actuator 400. The coupling is effected by a mounting assembly 6000. Referring to Figure 12, the mounting assembly 6000 includes a mounting adaptor 610, a universal ball joint linkage 620, and a quick release mechanism 630.

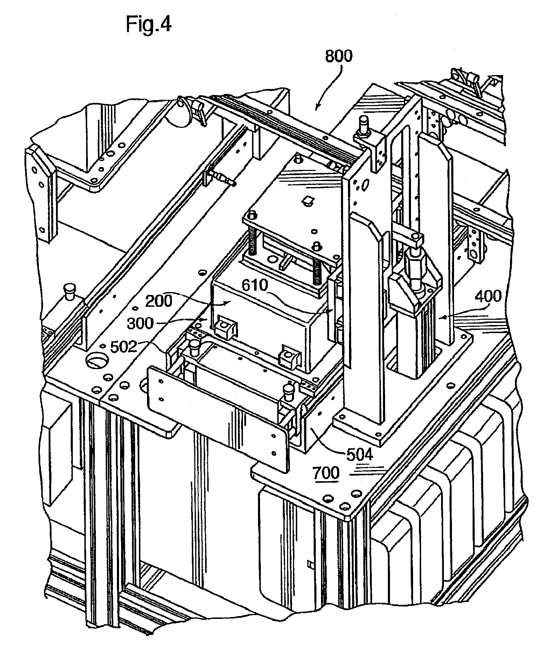

The mounting adaptor 610 is coupled to the actuator 400 (such as the driving cylinder illustrated in Figure 4), and translates the force applied by the actuator 400 to the push module 2000 through the universal ball linkage 620.

The universal ball joint linkage 620 functions as a self-alignment mechanism. In this respect, when the push module 2000 is compressed by the actuator 400 against the base module 3000, by virtue of the universal ball joint mechanism 620, the orientation of the push module 2000 is able to change in response to unbalanced reaction forces applied by the base module 3000, such that the push module 2000 assumes an orientation which enables its reception by the receiving slot 272. In this respect, the possibility of corner over-compression and uneven sealing of the RF shielding chamber 240 is prevented, substantially prevented, or at least mitigated.

In order to avoid losing control of the push module 2000 while the push module 2000 is being moved up and down by the actuator 400, four guiding shafts 602a, 602b, 602c, and 602d are provided to guide the movement of the push module 2000. Each one of the four guiding shafts 602a, 602b, 602c, and 602d is mounted at one end within receptacles provided in the push module 2000. The opposite end of each one of the four guiding shafts 602a, 602b, 602c, and 602d is received within receiving holes provided in the mounting adaptor 610. This limits the rotation of the pushing module 2000 about the vertical axis (z-axis). The receiving holes on the mounting adaptor 610 are oversized sufficiently so that the push module 2000, along with the shafts 602a, 602b, 602c, and 602d, can rotate about two axes (x-axis and y-axis), which are normal to the z-axis, and enable alignment of the push module 2000 relative to the base module 3000 when the push module 2000 is pressed against the base module 3000. As well, coil springs 603a, 603b, 603c, and 603d are provided about each shaft 602a, 602b, 602c, and 602d and also effect coupling of the mounting adaptor 610 to the push module 2000. The coil springs 603a - d are provided to limit movement of the push module 2000 relative to the mounting adaptor 610 (owing to the potential mobility range of the push module 2000 facilitated by the coupling of the push module 2000 to the mounting adaptor 610 through the universal ball joint linkage 620) when the push module 2000 is spaced apart from the base module 3000.

Referring to Figure 12, the quick release mechanism 630, which includes a quick release mechanism adaptor 632, a quick release connection pin 634, and a push module connection bar 636, is disposed between the universal ball joint linkage 620 and the push module 2000. A suitable quick-release pin is McMaster-CarrTM Part No. 90293a810. The push module connection bar 636 is included with the push module 2000. The quick release mechanism adaptor 632 extends from the linkage 620 and is connected to the push module connection bar 636 with the quick release connection pin 634. Throughbores provided in the adaptor 632 and the bar are co-operatively aligned to receive the pin 634 to effect connection between the adaptor 632 and the bar 636. To disconnect the adaptor 632 from the bar 636, the pin 634 is pulled out of the throughbores. In this respect, the connection between the adaptor 632 and the bar 636 is releasable.

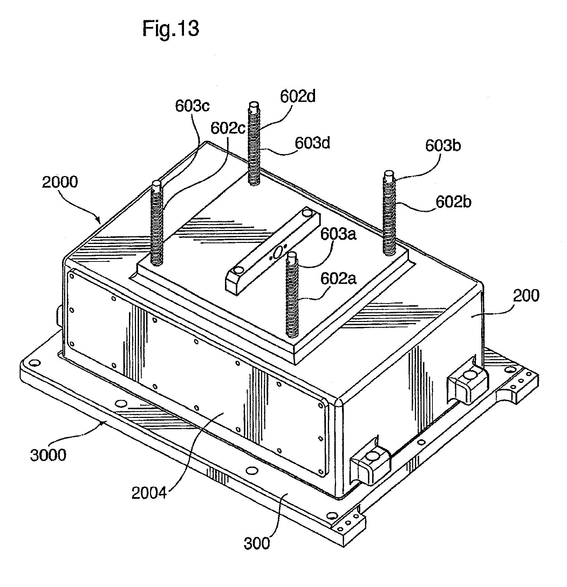

In some implementations, the push module 2000 can be disconnected from the actuator 400 (for example, in order to perform maintenance on the push module 2000). The disconnected push module 2000 is illustrated in Figure 13. Exemplary maintenance activities include: (a) visually checking the compression characteristics of the test pins 30b when the first enclosure portion 200 is closed against the second enclosure portion 300, (b) visually checking if there is any misalignment between the test pins 30b and the test pads on the PCB 100, (c) adding or replacing pusher fingers 50, and (d) checking the electrical connection using a multimeter. For example, the push module 2000 includes a selectively obscurable window (not shown). The selectively obscurable window includes a viewable condition and an obscured condition. In this viewable condition, the window permits visual inspection of the internal space 250 defined between the first enclosure portion 200 and the second enclosure portion 300 when the first enclosure portion 200 is seated on the second enclosure portion 300. In the obscured condition, at least a fraction of the window is obscured. For example, the at least a fraction of the window is the entire window. For example, the obscuring of the at least a fraction of the window is effected by a window curtain 2004 (e.g. a plate). The window curtain 2004 is releasably coupled to the pusher module 2000. For example, the window curtain 2004 is coupled to the pusher module 2000 with screws. In some implementation, the RF gasket 273 is disposed between the plate 2004 and the pusher module 2000. For example, the RF gasket 273 is Part Number 2411-1011-0146 supplied by Tech-Etch, Inc. of Plymouth, Massachusetts, U.S.A. For example, the RF gasket is provided within the receiving slot 272. Because the actuator 400 is no longer available, in order to provide sufficient force to effect the necessary contact between the electrical testers 30 and the PCB 100, the first enclosure portion 200 is urged into engagement with PCB 100 by tightening the first enclosure portion 200 against the second enclosure portion 300 with screws.

The base module 3000 includes the support block 404 and the probe plate 406. As described above, the probe plate 406 includes radio frequency ("RF") probes 30a, test pins 30b, and support pins 401. The probe plate 406 is secured to the support block 404 with screws. The PCB's 100 for testing are supported on the upper surface of the probe plate 406, and are located and further supported by the support pins 401. The base plate 402 functions as a stop to mitigate against over-compression of the PCB's 100 being tested while permitting reliable contacts between: (i) the PCB's being tested, and (ii) each of the RF probes 30a and the test pins 30b.

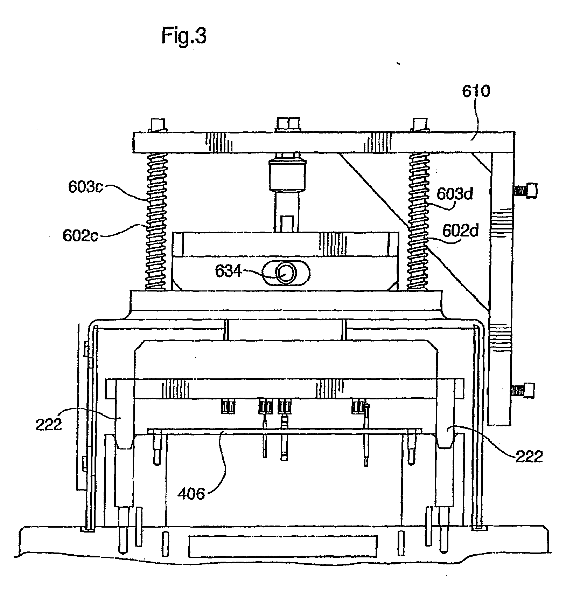

Referring to Figure 3, after the push fingers 216 make contact with the PCB 100 for testing and continue to move further downwardly, thereby further pressing down on the PCB 100, four position pins 222 (two are shown) mounted on the push plate slide into holes provided on the support block 404. The pins and holes co-operate such that each one of the pins is received in a corresponding one of the holes in a sliding fit relationship to thereby register the push module 2000 relative to the base module 3000 and thereby guide the push module 2000 as the push module is forced downwardly by the actuator 400.

Referring to Figure 4, the base module 3000 is mounted on top of two sliding rails 502, 504 which are attached to the platform 700 of the automatic testing machine 800. The mounting of the base module 3000 on the sliding rails facilitates the above-described maintenance operating. This is because, once the push module 2000 is disconnected from the actuator 400, as above-described, the chamber 240 (i.e. push module 2000 seated on the base module 3000) can be pulled out from the automatic testing machine along the sliding rails. After the maintenance is completed, the chamber 240 is pushed back into the automatic testing machine along the sliding rails. A pre-alignment of the push module 2000 of the chamber 240 and the mounting adaptor 610 is effected by aligning the shafts 602a, 602b, 602c, and 602d and the four holes on the top part of the mounting adaptor 610. The quick release pin 634 is inserted to effect re-coupling of the mounting adaptor 610 and the push module 2000.

From the open position (Figure 1), the push module 2000 is urged downwardly by the actuator (in this case, a driving cylinder 400) on the automatic testing machine 800. After the push plate 212 makes contact with the PCB 100 for testing and starts to move down further, four position pins mounted on the push plate 212, shown in Fig. 5, slide into the holes on the support blocks. The pins and holes are designed with a sliding fit to register the push module 2000, before the chamber 240 closes, and guide the push module 2000 while the push module 2000 is being further lowered until the lip 270 of the push module 2000 bottoms out within the slot 272. When the apparatus 10 is in this condition, the PCB 100 is ready for testing.

In some implementations, the PCB test fixture 10 is mechanically actuated using a lever. In other implementation, the PCB test fixture is vacuum actuated. Further, in some implementation, and as illustrated in Figure 4, the PCB test fixture 10 is gas (for example, air) pressure actuated.

It will be understood of course that modifications can be made to the implementation described herein.

## Claims

1. A printed circuit board ("PCB") test fixture (10) comprising:
a PCB support (20) configured for supporting a PCB (100) being tested in a PCB test position;
an electrical tester (30);
a first enclosure portion (200) including a pressing device (40) which is configured for effecting, with respect to a PCB (100) supported in the PCB test position on the PCB support (20), pressing of a circuit of the PCB (100) against the electrical tester (30) so as to provide an operative circuit;
a second enclosure portion (300) extending peripherally about the PCB support (20);
an actuator (400) coupled to a one of the first enclosure portion (200) and the second enclosure portion (300) and configured to effect an application of force to the one of the first enclosure portion (200) and the second enclosure portion (300);
wherein the PCB support (20) is disposed between the first and second enclosure portions (200, 300);
and wherein, when a contact surface portion of the first enclosure portion (200) is disposed in contact engagement along a contact interface with a contact surface portion of the second enclosure portion (300), and a one of the first enclosure portion (200) and the second enclosure portion (300) is being urged towards the other one of the first enclosure portion (200) and the second enclosure portion (300) by the actuator (400), and the urging of the one of the first enclosure portion (200) and the second enclosure portion (300) towards the other one of the first enclosure portion (200) and the second enclosure portion (300) by the actuator (400) effects production of a moment about an axis of the contact interface, the moment effects adjustment of the orientation of the first enclosure portion (200) relative to the second enclosure portion (300).

2. The PCB test fixture (10) as claimed in claim 1;
wherein, when a PCB (100) is supported in the PCB test position by the PCB support (20) and the providing of the operative circuit is being effected:
(a) the first enclosure portion (200) is seated on the second enclosure portion (300) such that an internal space is defined between the first enclosure portion (200) and the second enclosure portion (300), wherein the supported and PCB test disposed - PCB (100) is disposed within the internal space; and
(b) the actuator (400) is effecting the pressing device (40) to effect the provision of the operative circuit by pressing the supported and PCB test disposed - PCB (100) against the electrical tester (30).

3. The PCB test fixture (10) as claimed in claims 1 or 2, wherein the coupling of the actuator (400) to the one of the first enclosure portion (200) and the second enclosure portion (300) is configured to facilitate the adjustment of the orientation of the first enclosure portion (200) relative to the second enclosure portion (300).

4. The PCB test fixture (10) as claimed in claim 1, 2, or 3, wherein the actuator (400) is swivelly mounted to the one of the first enclosure portion (200) and the second enclosure portion (300).

5. The PCB test fixture (10) as claimed in any one of claims 1 to 4, wherein the coupling of the actuator (400) to the one of the first enclosure portion (200) and the second enclosure portion (300) is by way of a swivel coupling (620).

6. The PCB test fixture (10) as claimed in any one of claims 1 to 5, wherein the coupling of the actuator (400) to the one of the first enclosure portion (200) and the second enclosure portion (300) is by way of a ball joint (620).

7. The PCB test fixture (10) as claimed in any one of claims 1 to 6, wherein one of the first and second enclosure portions (200, 300) further comprises a lip (270), and the other one of the first and second enclosure portions (200, 300) further comprises a receiving slot (272), and wherein the adjustment of the orientation of the first enclosure portion (200) relative to the second enclosure portion (300) effects receiving of the lip (270) by the receiving slot (272).

8. The PCB test fixture (10) as claimed in any one of claims 1 to 6, wherein the adjustment of the orientation of the first enclosure portion (200) relative to the second enclosure portion (300) effects substantial alignment between the interfacing surfaces of each one of the first and second enclosure portions (200, 300).

9. The PCB test fixture (10) as claimed in claim 8, wherein the interfacing surface of the first enclosure portion (200) is a lip (270), and wherein the interfacing surface of the second enclosure portion (300) is a receiving slot (272), wherein the lip (270) is received within the receiving slot (272) when the substantial alignment is effected.

10. The PCB test fixture (10) as claimed in any one of claims 1 to 9, wherein the actuator (400) is coupled to the first enclosure portion (200).

11. The PCB test fixture (10) as claimed in claim 9, wherein the first enclosure portion (200) is an upper enclosure portion and the second enclosure portion (300) is a lower enclosure portion.

12. The PCB test fixture (10) as claimed in any one of claims 1 to 11, wherein the pressing device (40) effects the pressing of the circuit of a supported and PCB test disposed - PCB (100) against the electrical tester (30) by pressing against the supported and PCB test disposed - PCB (100).

13. The PCB test fixture (10) as claimed in claim 12, wherein the pressing of the pressing device (40) against the supported and PCB test disposed - PCB (100) is against a side surface of the supported and PCB test disposed - PCB (100) which is opposite to the side surface of the supported and PCB test disposed - PCB (100) which includes the circuit.

14. The PCB test fixture (10) as claimed in claim 13, wherein the pressing device (40) further comprises a plurality of pusher members (214).

15. The PCB test fixture (10) as claimed in any one of claims 1 to 14, wherein the actuator (400) further comprises a hydraulic actuator.

## Amended claims

### Amended claims in accordance with Rule 137(2) EPC.

**1.** A printed circuit board ,PCB, test fixture (10) comprising:
a PCB support (20) configured for supporting a PCB (100) being tested in a PCB test position;
an electrical tester (30);
a first enclosure portion (200) including a pressing device (40) which is configured for effecting, with respect to a PCB (100) supported in the PCB test position on the PCB support (20), pressing of a circuit of the PCB (100) against the electrical tester (30) so as to provide an operative circuit;
a second enclosure portion (300) extending peripherally about the PCB support (20);
an actuator (400) coupled to a one of the first enclosure portion (200) and the second enclosure portion (300) and configured to effect an application of force to the one of the first enclosure portion (200) and the second enclosure portion (300);
wherein the PCB support (20) is disposed between the first and second enclosure portions (200, 300);
and wherein, when a contact surface portion of the first enclosure portion (200) is disposed in contact engagement along a contact interface with a contact surface portion of the second enclosure portion (300), and a one of the first enclosure portion (200) and the second enclosure portion (300) is being urged towards the other one of the first enclosure portion (200) and the second enclosure portion (300) by the actuator (400), and the urging of the one of the first enclosure portion (200) and the second enclosure portion (300) towards the other one of the first enclosure portion (200) and the second enclosure portion (300) by the actuator (400) is capable of effecting production of a moment about any of a plurality of axes of the contact interface, and the moment effects adjustment of the orientation of the first enclosure portion (200) relative to the second enclosure portion (300).

**2.** The PCB test fixture (10) as claimed in claim 1;
wherein, when a PCB (100) is supported in the PCB test position by the PCB support (20) and the providing of the operative circuit is being effected:
(a) the first enclosure portion (200) is seated on the second enclosure portion (300) such that an internal space is defined between the first enclosure portion (200) and the second enclosure portion (300), wherein the supported and PCB test disposed - PCB (100) is disposed within the internal space; and
(b) the actuator (400) is effecting the pressing device (40) to effect the provision of the operative circuit by pressing the supported and PCB test disposed - PCB (100) against the electrical tester (30).

**3.** The PCB test fixture (10) as claimed in claims 1 or 2, wherein the coupling of the actuator (400) to the one of the first enclosure portion (200) and the second enclosure portion (300) is configured to facilitate the adjustment of the orientation of the first enclosure portion (200) relative to the second enclosure portion (300).

**4.** The PCB test fixture (10) as claimed in claim 1, 2, or 3, wherein the actuator (400) is swivelly mounted to the one of the first enclosure portion (200) and the second enclosure portion (300).

**5.** The PCB test fixture (10) as claimed in any one of claims 1 to 4, wherein the coupling of the actuator (400) to the one of the first enclosure portion (200) and the second enclosure portion (300) is by way of a swivel coupling (620).

**6.** The PCB test fixture (10) as claimed in any one of claims 1 to 5, wherein the coupling of the actuator (400) to the one of the first enclosure portion (200) and the second enclosure portion (300) is by way of a ball joint (620).

**7.** The PCB test fixture (10) as claimed in any one of claims 1 to 6, wherein one of the first and second enclosure portions (200, 300) further comprises a lip (270), and the other one of the first and second enclosure portions (200, 300) further comprises a receiving slot (272), and wherein the adjustment of the orientation of the first enclosure portion (200) relative to the second enclosure portion (300) effects receiving of the lip (270) by the receiving slot (272).

**8.** The PCB test fixture (10) as claimed in any one of claims 1 to 6, wherein the adjustment of the orientation of the first enclosure portion (200) relative to the second enclosure portion (300) effects substantial alignment between the interfacing surfaces of each one of the first and second enclosure portions (200, 300).

**9.** The PCB test fixture (10) as claimed in claim 8, wherein the interfacing surface of the first enclosure portion (200) is a lip (270), and wherein the interfacing surface of the second enclosure portion (300) is a receiving slot (272), wherein the lip (270) is received within the receiving slot (272) when the substantial alignment is effected.

**10.** The PCB test fixture (10) as claimed in any one of claims 1 to 9, wherein the actuator (400) is coupled to the first enclosure portion (200).

**11.** The PCB test fixture (10) as claimed in claim 9, wherein the first enclosure portion (200) is an upper enclosure portion and the second enclosure portion (300) is a lower enclosure portion.

**12.** The PCB test fixture (10) as claimed in any one of claims 1 to 11, wherein the pressing device (40) effects the pressing of the circuit of a supported and PCB test disposed - PCB (100) against the electrical tester (30) by pressing against the supported and PCB test disposed - PCB (100).

**13.** The PCB test fixture (10) as claimed in claim 12, wherein the pressing of the pressing device (40) against the supported and PCB test disposed - PCB (100) is against a side surface of the supported and PCB test disposed - PCB (100) which is opposite to the side surface of the supported and PCB test disposed - PCB (100) which includes the circuit.

**14.** The PCB test fixture (10) as claimed in claim 13, wherein the pressing device (40) further comprises a plurality of pusher members (214).

**15.** The PCB test fixture (10) as claimed in any one of claims 1 to 14, wherein the actuator (400) further comprises a hydraulic actuator.
